(19) Europäisches Patentamt
European Patent Office
Office européen des brevets

(11) **EP 2 423 171 A1**

(12) **DEMANDE DE BREVET EUROPEEN**

(43) Date de publication:
**29.02.2012 Bulletin 2012/09**

(51) Int Cl.:
***C03C 17/00*** (2006.01)    ***C03C 17/25*** (2006.01)
***H01L 31/00*** (2006.01)    ***B32B 17/00*** (2006.01)
***G02B 6/00*** (2006.01)    ***B60Q 3/02*** (2006.01)

(21) Numéro de dépôt: **11187873.2**

(22) Date de dépôt: **13.11.2007**

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **14.11.2006 FR 0654886**

(62) Numéro(s) de document de la (des) demande(s) initiale(s) en application de l'article 76 CBE:
**07858693.0 / 2 089 331**

(71) Demandeur: **Saint-Gobain Glass France**
**92400 Courbevoie (FR)**

(72) Inventeurs:
• **Huignard, Arnaud**
**60200 COMPIEGNE (FR)**
• **Rohaut, Nathalie**
**95390 SAINT-PRIX (FR)**
• **Besson, Sophie**
**60200 COMPIEGNE (FR)**

(74) Mandataire: **Lucas, Francois**
**SAINT-GOBAIN RECHERCHE**
**Département Propriété Industrielle**
**39, Quai Lucien Lefranc**
**93300 Aubervilliers (FR)**

Remarques:
Cette demande a été déposée le 04-11-2011 comme demande divisionnaire de la demande mentionnée sous le code INID 62.

(54) **Couche poreuse, son procédé de fabrication et ses applications**

(57)    La présente invention porte sur un substrat revêtu (1) d'une couche poreuse (2), le procédé de fabrication de la couche et ses applications. La couche poreuse (2) est essentiellement minérale et de type sol-gel présentant une série de pores fermés avec au moins la plus petite dimension caractéristique qui est, en moyenne, supérieure ou égale à 20 nm.

10'

**Figure 9**

EP 2 423 171 A1

**Description**

La présente invention se rapporte au domaine des matériaux poreux et notamment à une couche poreuse, son procédé de fabrication et ses applications.

On connaît déjà des couches poreuses essentiellement minérales obtenues par voie sol-gel. Le document EP1329433 divulgue ainsi une couche poreuse élaborée à partir d'un sol de tétraéthoxysilane (TEOS) hydrolysé en milieu acide avec un agent porogène à base de polyéthylène glycol tert phényle éther (dit Triton) à une concentration entre 5 et 50 g/l. La combustion de cet agent porogène à 500°C libère les pores. Appliquée sur un substrat en verre, cette couche est un antireflet servant pour des vitrines ou pour améliorer l'efficacité de cellules solaires.

La présente invention se propose d'élargir encore la gamme des couches poreuses disponibles, notamment réalisables à l'échelle industrielle, couches appliquées sur des substrats pour leur conférer de nouvelles fonctions ou propriétés, notamment optiques, électriques, magnétiques, physiques, chimiques voire de préférence d'améliorer les propriétés connues.

L'invention vise tout particulièrement une couche poreuse avec des propriétés durables et qui est facile à mettre en oeuvre.

A cet effet, l'invention propose un substrat revêtu au moins partiellement d'au moins une couche poreuse essentiellement minérale de type sol-gel, la couche présentant des pores fermés avec une plus petite dimension caractéristique qui est, en moyenne, supérieure ou égale à 20 nm, de préférence supérieure ou égale à 40 nm tout en restant préférentiellement submicronique en fonction des fonctionnalités et/ou applications visées.

D'une part, la demanderesse a constaté que des pores de grande taille étaient moins sensibles à l'eau et aux pollutions organiques susceptibles de dégrader ses propriétés notamment optiques (transmission et réflexion lumineuse, indice de réfraction ...). Cela est d'autant plus important pour des façades ou des cellules solaires, constamment exposées aux aléas climatiques.

D'autre part, l'obtention de pores de taille (dimensions(s) caractéristique(s)) et/ou de forme bien définie(s) et susceptibles d'être répartis dans l'espace selon une répartition souhaitée représente un enjeu capital dans les domaines notamment de l'optoélectronique, de l'optique non linéaire. La tortuosité des pores de la couche poreuse selon l'invention est faible.

La régularité dans la formation des pores est importante pour des applications où l'on recherche la production d'un effet ou d'une propriété homogène sur la surface du substrat, en particulier lorsque la propriété est liée à la quantité de matière, la taille, la forme d'une particule ou l'agencement de celles-ci, ce qui est le cas notamment des propriétés optiques (antireflet, indice de réfraction adapté...).

La couche poreuse selon l'invention peut ainsi présenter tout particulièrement une répartition sensiblement homogène dans toute son épaisseur, depuis l'interface avec le substrat ou avec une sous-couche éventuelle jusqu'à l'interface avec l'air ou un autre milieu. La répartition homogène peut être tout particulièrement utile pour établir des propriétés isotropes de la couche.

La plus petite dimension caractéristique des pores (et de préférence la plus grande dimension également) peut être encore plus préférentiellement supérieure ou égale à 30 nm et de préférence inférieure à 100 nm voire à 80 nm. Cela dépend des applications visées, de l'épaisseur de la couche.

La porosité peut être en outre monodisperse en taille, la taille des pores étant alors calibrée à une valeur minimale de 20 nm, de préférence 40 nm encore plus préférentiellement 50 nm et de préférence inférieure à 100 nm. Cela dépend des applications visées, de l'épaisseur de la couche.

La majorité des pores fermés, (voire entre 80% ou plus), peuvent avoir de préférence une plus petite dimension caractéristique, et de préférence une plus grande dimension également, entre 20 et 80 nm.

La proportion en volume de pores peut être comprise entre 10% à 90%, de préférence inférieure ou égale à 80%.

La couche poreuse selon l'invention est mécaniquement stable, elle ne s'effondre pas même pour des fortes concentrations de pores. Les pores peuvent être aisément séparés les uns des autres, bien individualisés. Et la couche poreuse selon l'invention est susceptible d'une cohésion et d'une tenue mécanique excellentes. On préfère tout particulièrement une couche poreuse comportant une phase solide (essentiellement) continue, formant ainsi les murs denses des pores, plutôt qu'une phase solide principalement sous forme de (nano)particules ou de cristallites.

Les pores peuvent avoir une forme allongée, notamment en grain de riz. Encore plus préférentiellement, les pores peuvent avoir une forme sensiblement sphérique ou ovale. On préfère que la majorité des pores fermés, voire au moins 80% d'entre eux, aient une forme donnée sensiblement identique, notamment allongée, sensiblement sphérique ou ovale.

La couche poreuse selon l'invention peut avoir une épaisseur avantageusement comprise entre 10 nm et 10 μm (ces valeurs limites étant incluses), en particulier 50 nm et 1 μm et encore plus préférentiellement entre 100 et 200 nm, notamment entre 100 et 150 nm, pour la fonction antireflet dans le visible et/ou proche infrarouge.

De nombreux éléments chimiques peuvent être à la base de la couche poreuse. Elle peut comprendre comme matériau constitutif essentiel au moins un composé de l'un au moins des éléments : Si, Ti, Zr, Al, ou encore W, Sb, Hf, Ta, V, Mg, Mn, Co, Ni, Sn, Zn, Ce. Il peut s'agir notamment d'un oxyde simple ou d'un oxyde mixte de l'un au moins des éléments précités.

De préférence, la couche poreuse selon l'invention peut être essentiellement à base de silice notamment pour son adhésion et sa compatibilité avec un substrat verrier.

La structuration de la couche en pores est liée à la technique de synthèse de type sol-gel, qui permet de condenser la matière essentiellement minérale (c'est-à-dire minérale ou hybride organique minérale) avec un agent porogène convenablement choisi en particulier de taille(s) et/ou de forme(s) bien définie(s) (allongé, sphérique, ovale etc). Les pores peuvent être de préférence vides ou éventuellement être remplis.

On peut ainsi choisir de la silice élaborée à partir de tétraétoxysilane (TEOS), de silicate de sodium, de lithium ou de potassium ou des matériaux hybrides obtenus à partir de précurseurs de type organosilane dont la formule générale est

$$R2_n \, Si(OR1)_{4-n}$$

avec n un entier entre 0 et 2, R1 une fonction alkyl de type $C_xH_{2x+1}$, R2 un groupement organique comprenant par exemple une fonction alkyl, époxy, acrylate, méthacrylate, amine, phényle, vinyle. Ces composés hybrides peuvent être utilisés mélangés ou seuls, en solution dans l'eau ou dans un mélange eau/alcool à un pH approprié.

Comme couche hybride, on peut choisir une couche à base de méthyltriéthoxysilane (MTEOS), un organosilane à groupement organique non réactif. Le MTEOS est un organosilane qui possède trois groupements hydrolysables et dont la partie organique est un méthyle, non réactif.

Si l'on souhaite conserver les fonctions organiques, on peut choisir un solvant extracteur ad hoc pour éliminer l'agent porogène choisi organique, par exemple le THF pour le polyméthacrylate de méthyle (PMMA). La couche poreuse selon l'invention peut être susceptible d'être obtenue avec au moins un agent porogène solide. L'agent porogène solide donne la possibilité de faire varier la taille des pores de la couche par un choix judicieux de sa taille.

L'agent porogène non localisé de l'art antérieur est de forme indéterminée et se répand dans la structure de façon incontrôlée. L'agent porogène solide selon l'invention permet quant à lui une meilleure maîtrise de la taille des pores, notamment l'accès à des grandes tailles, une meilleure maîtrise de l'organisation des pores notamment une distribution homogène, ainsi qu'une meilleure maîtrise du taux de pores dans la couche et une meilleure reproductibilité.

L'agent porogène solide selon l'invention se distingue également d'autres agents porogènes connus tels que des micelles de molécules tensioactives cationiques en solution et, éventuellement, sous forme hydrolysée, ou de tensioactifs anioniques, non ioniques, ou des molécules amphiphiles, par exemple des copolymères blocs. De tels agents génèrent des pores sous forme de canaux de petite largeur ou des pores plus ou moins ronds de petite taille entre 2 et 5 nm.

Toutefois, il peut être utile de cumuler diverses formes et/ou tailles de pores dans une seule couche (mono ou multicouche).

L'agent porogène selon l'invention peut être de préférence plein voire creux, mono ou multi composant, minéral ou organique ou hybride.

L'agent peut être de préférence sous forme particulaire, de préférence (quasi)sphérique. Les particules peuvent être de préférence bien individualisées, ce qui permet de contrôler aisément la taille des pores. La surface de l'agent porogène peut être indifféremment rugueuse ou lisse. Comme agent porogène creux, on peut citer en particulier des billes de silice creuses. Comme agent porogène plein, on peut citer des billes polymériques monocomposant ou bicomposant notamment avec un matériau coeur et une coque.

L'agent porogène choisi polymérique peut être préférentiellement éliminé pour obtenir la couche poreuse dont les pores peuvent avoir sensiblement la forme et la taille de cet agent porogène.

L'agent porogène solide, notamment polymérique, peut être disponible sous plusieurs configurations. Il peut être stable en solution, typiquement on utilise une dispersion colloïdale, ou être sous forme d'une poudre redispersable dans un solvant aqueux ou alcool correspondant au solvant utilisé pour former le sol ou à un solvant compatible avec ce solvant.

On peut choisir en particulier un agent porogène en l'un des polymères suivants :

- en polyméthacrylate de méthyle (PMMA),
- en copolymères méthyl (méth)acrylate/acide (méth)acrylique,
- en polymères polycarbonates, polyester, polystyrène, etc
  ou d'une combinaison de plusieurs de ces matériaux.

Un autre type d'agent porogène servant pour former la couche poreuse selon l'invention peut être sous forme de nanogouttes d'un premier liquide, notamment à base d'huile, dispersées dans un deuxième liquide, notamment à base d'eau, le premier liquide et le deuxième liquide étant non miscibles. Il s'agit par exemple d'une nanoémulsion.

Les nanogouttes jouent le rôle d'agent porogène avec une taille est bien définie. Après élimination des nanogouttes, on obtient des pores sphériques sensiblement de la taille des nanogouttes.

Le deuxième liquide, qui peut être de préférence à base d'eau, peut servir à condenser le matériau constitutif de la couche. De manière préférentielle, on peut choisir un sol précurseur du matériau constitutif de la couche compatible avec ce deuxième liquide et incompatible avec le premier liquide pour ne pas déstabiliser la nanoémulsion.

Il peut s'agir en particulier de nanogouttes d'huile dispersées dans un milieu aqueux grâce à un système de tensioactifs qui assure la stabilité. Ces nanogouttes sont généralement fabriquées par fragmentation mécanique d'une phase huileuse dans une phase aqueuse en présence de tensioactifs. La taille souhaitée des nanogouttes peut être obtenue notamment grâce à au moins un passage dans un homogénéiseur haute pression.

On peut notamment choisir les nanoémulsions utilisées dans les domaines de la cosmétique et de la santé, par exemple celles décrites dans la demande de brevet WO0205683.

Les nanogouttes selon l'invention peuvent contenir au moins une huile choisie de préférence parmi les huiles d'origine animale ou végétale, les huiles minérales, les huiles de synthèse, les huiles de silicone, les hydrocarbures notamment aliphatiques, et leurs mélanges.

On peut sélectionner en particulier les huiles suivantes :

- les huiles paraffines ;
- les huiles végétales hydrocarbonées.

Pour renforcer encore davantage la tenue hydrolytique de la couche poreuse selon l'invention, on peut aussi choisir de superposer une couche oléophobe et/ou hydrophobe greffée, par exemple à base de l'organosilane fluoré décrit dans les brevets US-A-5 368 892 et US-A-5 389 427, ainsi qu'à base d'alkylsilane(s) fluoré(s) hydrolysable(s) décrit(s) dans la demande de brevet EP692463, notamment un perfluoroalkylsilane de formule :

$$CF_3\text{-}(CF_2)_n\text{-}(CH_2)_m\text{-}SiX_3,$$

avec n de 0 à 12, m de 2 à 5, X une fonction hydrolysable par exemple chloré ou alkoxy.

Selon la nature de la surface destinée à être revêtue de la couche, il peut être recommandé, voire nécessaire, d'interposer une couche de primaire afin de favoriser l'adhésion de la couche à son support et/ou d'obtenir simplement une qualité suffisante de cette adhésion. A cette fin, on dépose sur le substrat, préalablement à sa mise en contact avec la composition contenant le précurseur du matériau constitutif de la couche poreuse, une couche de potentiel isoélectrique supérieur ou égal au pH de ladite composition. On peut choisir notamment une sous-couche primaire du type tétrahalogéno- ou tétraalkoxy-silane, comme indiquée dans la demande de brevet EP0484746.

De préférence, la couche poreuse de l'invention est formée avec interposition d'une sous-couche à base de silice ou de dérivés au moins partiellement oxydés du silicium choisi parmi le dioxyde de silicium, des oxydes de silicium sous stoechiométriques, l'oxycarbure, l'oxynitrure ou l'oxycarbonitrure de silicium.

La sous-couche s'avère utile quand la surface sous-jacente est en verre silicosodocalcique car elle joue le rôle de barrière aux alcalins.

La sous-couche s'avère utile quand la surface sous-jacente est en plastique car elle permet de renforcer l'adhésion de la couche poreuse.

Cette sous-couche comprend donc avantageusement Si, O, éventuellement du carbone et de l'azote. Mais elle peut comprendre aussi des matériaux minoritaires par rapport au silicium, par exemple des métaux comme Al, Zn ou Zr. La sous-couche peut être déposée par sol-gel ou par pyrolyse, notamment par pyrolyse en phase gazeuse (CVD). Cette dernière technique permet d'obtenir des couches en $SiO_xC_y$, ou en $SiO_2$ assez aisément, notamment par dépôt directement sur le ruban de verre float dans le cas de substrats verriers. Mais on peut aussi effectuer le dépôt par une technique sous vide, par exemple par pulvérisation cathodique à partir d'une cible de Si (éventuellement dopée) ou d'une cible en sous-oxyde de silicium (en atmosphère réactive oxydante et/ou nitrurante par exemple). Cette sous-couche a de préférence une épaisseur d'au moins 5 nm, notamment une épaisseur comprise entre 10 et 200 nm, par exemple entre 80 et 120 nm.

Le matériau constitutif de la couche peut être préférentiellement choisi pour que celle-ci soit transparente à certaines longueurs d'onde. En outre, la couche peut présenter un indice de réfraction à 600 nm et/ou à 550 nm au moins inférieur de 0,1 à l'indice de réfraction d'une couche de même matière minérale dense (sans pores), encore plus préférentiellement 0,2 ou 0,3. De préférence cet indice de réfraction à 600 nm et/ou à 550 nm peut être inférieur ou égal à 1,3 voire inférieur ou égal à 1,1 voire encore même proche de 1 (par exemple 1,05).

A titre indicatif, à 600 nm, une couche en silice non poreuse a typiquement un indice de réfraction de l'ordre de 1,45, une couche en oxyde de titane a un indice de réfraction de l'ordre de 2, une couche en zircone a un indice de réfraction de l'ordre de 1,7.

On peut ajuster à façon l'indice de réfraction en fonction du volume de pores. On peut utiliser en première approximation la relation suivante pour le calcul de l'indice :

$n = f.n_1 + (1-f).n_{pores}$ où f est la fraction volumique du matériau constitutif de la couche et $n_1$ son indice de réfraction et $n_{pores}$ est l'indice des pores généralement égal à 1 s'ils sont vides.

En choisissant de la silice, on peut descendre aisément jusqu'à 1,05 et pour toute épaisseur.

On peut aussi ajuster à façon l'épaisseur de la couche en choisissant le taux de solvant adéquat.

Pour une application antireflet, l'effet est optimal lorsque l'indice de réfraction est égal à la racine carré de l'indice du substrat, soit pour du verre d'indice 1,5 un indice de 1,23, et le produit indice par l'épaisseur est égal à un quart de longueur d'onde, aussi de préférence l'indice de la couche poreuse peut être inférieur à 1,3 et l'épaisseur être autour de 120 nm, pour une réflexion minimum autour de 600 nm, ou être autour de 110 nm à 550 nm.

L'indice de réfraction de la couche poreuse selon l'invention est invariant, peu sensible à l'environnement.

Le matériau constitutif de la couche peut être préférentiellement la silice, hybride ou minérale, du fait du faible indice de ce matériau comme déjà expliqué. Dans ce cas, la silice peut avantageusement être dopée pour améliorer encore davantage sa tenue hydrolytique dans le cas d'applications où une bonne résistance est nécessaire (façades, extérieurs etc). Les éléments dopants peuvent de préférence être choisis parmi Al, Zr, B, Sn, Zn. Le dopant est introduit pour remplacer les atomes de Si dans un pourcentage molaire pouvant de préférence atteindre 10%, encore plus préférentiellement jusqu'à 5%.

Au sens de l'invention, et en l'absence de précision, on comprend par "couche", soit une couche unique (monocouche) soit une superposition de couches (multicouche).

Dans une conception avantageuse, la couche peut être sous forme d'une multicouche poreuse, les couches poreuses de la multicouche ayant des pores de tailles distinctes et/ou en quantités distinctes. On peut préférer notamment fabriquer des couches de plus en plus poreuses avec l'épaisseur donc en s'éloignant du substrat porteur de la multicouche, pour donner un empilement de couches avec un indice de réfraction dans le visible décroissant avec l'épaisseur croissante, ceci pour une fonction antireflet encore améliorée. La multicouche peut avoir de préférence une épaisseur entre 100 et 150 nm, de préférence autour de 120 nm, avec un indice moyen de 1,2 à 1,25. La somme du produit indice par épaisseur de toutes les monocouches peut être égale au produit indice par épaisseur de l'équivalent monocouche.

Dans un premier exemple, pour un substrat d'indice 1,5, la couche poreuse la plus proche du substrat peut avoir un indice de 1,4 (voire être une couche de silice non poreuse) et celle la plus éloignée de 1,1 voire 1,05.

Dans un deuxième exemple, on choisit (partant du substrat) une première couche d'indice n1 égale à 1,35 et une épaisseur de 40 nm $\pm$ 10 nm, une deuxième couche d'indice n2 égale à 1,25 et une épaisseur de 40 nm $\pm$ 10 nm et une troisième et dernière couche d'indice n3 égale à 1,15 et une épaisseur de 40 nm $\pm$ 10 nm.

La couche poreuse peut être continue ou discontinue et occuper sensiblement entièrement la face principale du substrat revêtu.

Par ailleurs, le substrat peut être de préférence un substrat essentiellement transparent, notamment à base de verre et/ou de polymère(s), de plastique.

Le substrat porteur de la couche poreuse affecte généralement une forme essentiellement plane ou bi-dimensionnelle avec un contour variable, tel que par exemple une plaque ou une galette, mais peut aussi affecter une forme volumique ou tri-dimensionnelle constituée de l'assemblage de surfaces essentiellement planes, par exemple en forme de cube ou parallélépipède, ou non.

Le substrat peut être plan voire courbé, organique ou minéral, notamment en verre sous forme d'une feuille, dalle, tube, fibre ou tissu.

A titre d'exemples de matériaux verriers, on peut citer le verre float (ou verre flotté) de composition sodo-calcique classique, éventuellement durci ou trempé par voie thermique ou chimique, un borosilicate d'aluminium ou de sodium ou toute autre composition.

Le verre peut être coloré, teinté dans la masse ou avec une couche décorative.

Le verre peut être clair, extra-clair, à très faible teneur en oxyde(s) de fer. Il s'agit par exemple des verres commercialisés dans la gamme « DIAMANT » par SAINT-GOBAIN GLASS.

De manière avantageuse, la face principale qui est revêtue de la couche poreuse peut présenter un relief macroscopique en creux ou en reliefs, par exemple des motifs en pyramides, notamment de profondeur allant de l'ordre de fraction(s) du millimètre à quelques millimètres notamment allant de 0,001 mm à 5 mm, par exemple allant de 1 à 5 mm.

De préférence, les motifs sont le plus proche possible les uns des autres, et ont par exemple leurs bases distantes de moins de 1 mm, et de préférence de moins de 0,5 mm, et encore plus préférentiellement sont jointifs.

Les motifs peuvent par exemple avoir la forme de cône ou de pyramide à base polygonale, comme triangulaire ou carrée ou rectangulaire ou hexagonale ou octogonale, lesdits motifs pouvant être convexes, c'est-à-dire venant en excroissance par rapport au plan général de la face texturée, ou être concaves, c'est-à-dire venant en creux dans la masse de la plaque.

Pour le cas où les motifs ont la forme de cône ou de pyramide, on préfère que tout demi-angle au sommet dudit cône ou de ladite pyramide soit inférieur à 70°, et de préférence soit inférieur à 60°, par exemple aille de 25° à 50°.

On peut choisir par exemple des verres plans imprimés texturés tels que les verres commercialisés dans la gamme « ALBARINO » par SAINT-GOBAIN GLASS.

Un substrat transparent avec une face ainsi texturée et revêtue cumule les effets :

- le piégeage de la lumière comme montré dans la demande de brevet WO2003/046617 incorporée par référence, demande qui décrit par exemple une plaque texturée présentant à sa surface un ensemble de motifs concaves alignés et totalement jointifs, lesdits motifs ayant la forme de pyramides à base carrée,
- l'aspect antireflet.

A titre d'exemples de matières plastiques, on peut citer le poly(méthacrylate de méthyle (PMMA), polyvinylbutyral (PVB), polycarbonate (PC) ou polyuréthane (PU), copolymère éthylène/acétate de vinyle (EVA) thermoplastique, poly(téréphtalate d'éthylène) (PET), poly(téréphtalate de butylène) (PBT), copolymères polycarbonates/polyester, copolymère cyclooléfinique du type éthylène/norbornène ou éthylène/cyclopentadiène, les résines ionomères, par exemple un copolymère éthylène/acide (méth)acrylique neutralisé par une polyamine, les thermodurcissables ou thermoréticulables tels que polyuréthane, polyester insaturé (UPE), copolymère éthylène/acétate de vinyle ...) ou d'une combinaison de plusieurs de ces matériaux.

Le substrat est constitué, de préférence, d'un matériau verrier ou d'une matière plastique du type cité précédemment. Il peut consister en une feuille unique, un feuilleté formé de plusieurs feuilles assemblées ou bien être un objet massif dont la surface destinée à recevoir la couche est lisse, en général, mais non nécessairement plane. Le substrat peut être un intercalaire de feuilletage.

Le substrat peut être un vitrage en verre silicosodocalcique, notamment extraclair, et le substrat revêtu peut présenter :

- une transmission du rayonnement lumineux supérieure ou égale à 91% voire supérieure ou égale 92% ou même 93% ou 94% à 600 nm et/ou à 550 nm ou de préférence sur toute la gamme visible, soit typiquement une augmentation d'au moins 2% voire 3% ou 4% de la transmission du rayonnement lumineux du substrat transparent porteur,
- et/ou une réflexion du rayonnement lumineux inférieure ou égale à 7%, voire inférieure ou égale à 4%, à 600 nm et/ou à 550 nm ou de préférence sur toute la gamme visible.

Pour les applications photovoltaïques, on choisit de préférence comme longueur d'onde caractéristique de 600 nm et pour des antireflets de type vitrine, on choisit plutôt 550 nm.

Les applications notamment antireflets du substrat revêtu de la couche poreuse sont diverses :

- comme vitrage utilitaire type verre d'aquarium, de vitrine, de serre, de comptoir, de vitrage de protection d'un tableau,
- pour le mobilier urbain (panneau d'affichage, abri de bus...) ou l'aménagement intérieur (panneau décoratif) ou l'ameublement (façade de meuble ...),
- pour un véhicule de transport aéronautique, maritime, terrestre (ferroviaire, routier), du type pare-brise, lunette arrière, toit auto, vitre latérale,
- pour le bâtiment (fenêtre, porte-fenêtre),
- pour l'électroménager (porte de réfrigérateur, de four, vitrine de meuble, plaque vitrocéramique).

En applications notamment intérieures, on peut encore citer des vitrages destinés à protéger des tableaux, à faire des vitrines de musées, présentoirs, des cloisons intérieures (hôpitaux, salles blanches, de contrôle), des studios de télévision et d'enregistrement, des cabines de traduction. En applications extérieures, on peut encore citer les vitrines de magasins, baies vitrées de restaurant, tours de contrôle (aéroports ports), vitrages extérieurs de séparation (des spectateurs dans les stades ...). On peut aussi citer, les panneaux signalétiques ou publicitaires (gares, aéroports etc), les cabines de commandes d'engins de chantiers (grues, tracteurs).

Dans les applications les plus conventionnelles des antireflets, on les utilise pour diminuer la réflexion lumineuse des substrats, pour en augmenter la transmission lumineuse. Leur optimisation se fait donc en prenant en compte uniquement les longueurs d'onde dans le domaine du visible.

Pour une meilleure efficacité dans ces applications conventionnelles des antireflets, le substrat peut comprendre une couche poreuse de préférence sur chacune des faces principales.

Ce substrat revêtu d'une couche antireflet sur chaque face peut présenter une transmission lumineuse supérieure ou égale à 92% voire supérieure ou égale 95% ou même 96% à 97% à 550 nm ou de préférence sur toute la gamme visible, soit typiquement une augmentation d'au moins 3% voire 5% ou 6% de la transmission lumineuse du substrat transparent porteur.

Par ailleurs, le substrat revêtu peut ainsi avoir une transmission sur une gamme de longueurs d'onde comprise entre 400 et 1200 nm d'au moins 90%, pour un antireflet large bande.

En outre, le substrat revêtu de la couche poreuse selon l'invention peut être utilisé comme substrat pour dispositif électroluminescent organique (« OLED » en anglais), la face revêtue étant la face externe.

Cette couche poreuse permet d'augmenter l'extraction des rayons déjà sortants. On peut choisir d'optimiser l'extraction à incidence oblique notamment autour de 30°.

Des exemples d'empilements électroluminescents organiques sont par exemple décrits dans le document US6645645.

Les OLED sont généralement dissociés en deux grandes familles suivant le matériau organique utilisé. Si les couches électroluminescentes sont des petites molécules, on parle de SM-OLED (Small Mollecule Organic Light Emitting Diodes en anglais). Si les couches électroluminescentes organiques sont des polymères, on parle de PLED (Polymer Light Emitting Diodes en anglais).

Par ailleurs, on peut aussi avoir besoin d'augmenter la transmission de substrats transparents, et pas uniquement dans le domaine du visible, pour des applications particulières. Il s'agit notamment des panneaux solaires, en particulier les collecteurs solaires thermiques ou encore les cellules photovoltaïques, par exemple des cellules au silicium.

Ces cellules photovoltaïques ont besoin d'absorber le maximum de l'énergie solaire qu'elles captent, dans le visible, mais aussi au-delà, tout particulièrement dans le proche infrarouge afin de maximiser leur efficacité quantique qui caractérise leur rendement de conversion énergétique.

Il est donc apparu, pour augmenter leur rendement, d'optimiser la transmission de l'énergie solaire à travers ce verre dans les longueurs d'onde qui importent pour les cellules photovoltaïques.

Obtenir une transmission lumineuse élevée dans le domaine couvrant les longueurs d'onde du visible et jusqu'à celles du proche infrarouge garantit un rendement de conversion énergétique élevée, cette transmission élevée se traduisant au niveau de la cellule par une variation d'un paramètre caractéristique ($I_{sc}$ pour Intensity Short Circuit) qui conditionne justement ce rendement de conversion.

Ainsi, l'invention a aussi pour objet les substrats revêtus selon l'invention en tant que substrats extérieurs pour au moins une cellule photovoltaïque, la face revêtue étant naturellement la face externe (opposée à la cellule).

On commercialise généralement ce type de produit sous forme de cellules photovoltaïques montées en série et disposées entre deux substrats, le substrat extérieur étant transparent, notamment un verre. C'est l'ensemble des substrats, de la ou des cellules photovoltaïques que l'on désigne et que l'on vend sous le nom de « module solaire ».

Le substrat revêtu dont la face externe est revêtue peut donc être un substrat extérieur transparent d'un module solaire comprenant une ou une pluralité de cellules photovoltaïques notamment du type Si monocristallin ou polycristallin (par exemple un « wafer » ou galette) ou a-Si, ou CIS, CdTe, GaAs ou GaInP.

Selon une forme de réalisation du module solaire selon l'invention, celui-ci dispose d'une augmentation de son rendement, exprimée en densité de courant intégrée d'au moins 2,5% voire 2,9%, ou même jusqu'à 3,5% en utilisant un verre extraclair revêtu par rapport à un module utilisant un substrat extérieur en verre extraclair dépourvu d'antireflet.

Selon une forme de réalisation du module solaire, celui-ci peut comporter un premier substrat, choisi plan et en verre notamment coloré, et une cellule photovoltaïque, associée à un deuxième substrat plan, notamment en verre, et feuilletée avec un intercalaire de feuilletage au premier substrat. Et une couche poreuse à bas indice peut être déposée sur la face de feuilletage du premier substrat voire être déposée sur la face de l'intercalaire de feuilletage côté premier substrat.

L'invention peut aussi porter sur un vitrage multiple comportant un premier substrat plan, de préférence en verre notamment clair ou coloré, et un deuxième substrat plan, de préférence en verre, feuilleté avec un intercalaire de feuilletage au premier substrat. Et une couche poreuse bas indice peut être déposée sur la face de feuilletage du premier substrat voire être déposée sur la face de l'intercalaire de feuilletage côté premier substrat.

Ce vitrage multiplie peut servir dans toutes les applications déjà citées (bâtiment, automobile, intérieur comme extérieur...).

Cette couche poreuse agit comme un séparateur optique entre le verre extérieur et la cellule photovoltaïque, ou entre le premier et le deuxième substrat. Cela permet de garder l'aspect recherché, par exemple un aspect coloré, teinté, ce qui est particulièrement utile pour une façade de bâtiment. L'effet est optimal si l'on choisit un indice de réfraction le plus bas possible.

Aussi dans ces dernières applications de feuilletage, la couche poreuse bas indice, de préférence telle que déjà décrite précédemment (larges pores, fabrication par billes ou nanogouttes ...), peut être d'indice optique n2 inférieur à l'indice optique n1 du premier substrat, notamment n2-n1 supérieur ou égale à 0,1, voir 0,2 et par exemple jusqu'à 0,4, de préférence dans toute la gamme du visible.

Par exemple on choisit un indice de 1, 4 voire jusqu'à 1,1 notamment pour un premier substrat verre d'indice 1,5.

L'épaisseur de la couche poreuse formant séparateur optique peut être de préférence supérieure ou égale 200 nm, voire 400 nm et de préférence inférieure à 1 μm.

Dans une troisième configuration feuilletée, on propose une structure feuilletée lumineuse comportant :

- un premier substrat transparent et plan, d'indice optique n1 donné, notamment un verre clair ou extraclair voire un plastique,
- un deuxième substrat plan teinté dans la masse, notamment un verre teinté,
- un intercalaire de feuilletage, entre les premier et deuxième substrats,
- une couche poreuse formant séparateur optique, déposée sur l'intercalaire de feuilletage ou sur le premier substrat, la couche poreuse étant d'indice optique n2, la différence n2 - n1 étant supérieure ou égale à 0,1 voire 0,2, et par exemple jusqu'à 0,4, de préférence dans toute la gamme du visible,
- une source de lumière couplée à la tranche du premier substrat, notamment des diodes électroluminescentes (« led » en anglais),
- un réseau rétrodiffusant interne entre la couche poreuse et le premier substrat, et/ou un réseau diffusant externe sur la face externe du premier substrat.

La couche poreuse formant séparateur optique renvoie les rayons lumineux dans le premier substrat transparent formant guide optique.

L'épaisseur de la couche poreuse peut être de préférence supérieure ou égale 200 nm, voire 400 nm et de préférence inférieure à 1 $\mu$m.

Par exemple on choisit pour la couche poreuse un indice de 1, 4 à 1,1 notamment pour un premier substrat verre d'indice 1,5.

En cas de réseau rétrodiffusant interne, cette couche poreuse peut être déposée uniquement entre le réseau interne ou bien recouvrir également le réseau interne.

Le réseau interne est rétrodiffusant, de préférence de facteur de réflexion diffuse supérieur ou égal à 50%, voire à 80%.

Le réseau externe est diffusant, sert pour extraire la lumière, et de préférence de facteur de transmission diffuse supérieur ou égal à 50%, voire à 80%.

Le réseau diffusant ou rétrodiffusant peut être formé de motifs diffusants par exemple de largeur (moyenne) de 0,2 mm à 2 mm, préférentiellement inférieure à 1 mm et d'épaisseur micronique par exemple de 5 à 10 $\mu$m. L'espacement (moyen) entre les motifs peut être 0,2 à 5 mm. Pour former un réseau on peut texturer une couche.

Le réseau diffusant ou rétrodiffusant peut être de préférence essentiellement minéral, à base de liant minéral et/ou de particules diffusantes minérales.

A titre d'exemple de réseau rétrodiffusant on peut choisir une couche diffusante telle que décrite dans la demande de brevet français publiée FR 2 809 496

Le deuxième substrat teinté peut préserver par exemple de la chaleur venant du soleil. On peut garder une certaine transparence pour une vision de l'extérieur par exemple pour les toits de véhicule de transport maritime, terrestre (automobile, véhicules industriels...).

On choisit par exemple les verres dénommés VG10 ou VG40, de la gamme VENUS vendus par la société SAINT GOBAIN GLASS.

Le verre VENUS VG10 a les caractéristiques suivantes : $T_L$ entre 10 et 15%, TE entre 8 et 12,5% (selon la norme TE-PM2) en fonction des épaisseurs. Le verre VENUS VG40 a les caractéristiques suivantes : $T_L$ entre 35 et 42%, TE entre 22 et 28% (selon la norme TE-PM2) en fonction des épaisseurs.

Pour une application bâtiment, on peut par exemple utiliser des verres teintés dans la masse bronze, gris ou vert de la gamme PARSOL vendus par la société SAINT GOBAIN GLASS. Par exemple, le verre PARSOL GRIS a les caractéristiques suivantes : $T_L$ entre 26 et 55% (selon Illuminant D65), TE entre 29 et 57% (selon la norme PM2) en fonction des épaisseurs.

L'éclairage peut être décoratif, d'ambiance, coloré ou non. L'éclairage peut être homogène ou non, en fonction de applications visées (vitrage à logo, signalétique, décor...).

Dans la structure feuilletée lumineuse, l'intercalaire revêtu ou, de préférence, le premier substrat revêtu peut être le substrat revêtu de la couche poreuse déjà décrite précédemment.

La structure feuilletée éclairante, peut être tout particulièrement un toit lumineux, une porte d'un véhicule, un double vitrage lumineux notamment pour le bâtiment, l'extérieur et l'intérieur tels que des façades, cloisons, portes, fenêtres, table ou étagère.

Dans ces exemples de structures feuilletées, la couche poreuse formant séparateur optique peut alternativement être formée suivant différentes techniques de l'art antérieur.

Dans un premier mode de réalisation, les pores sont les interstices d'un empilement non compact des billes nanométriques, notamment de silice, cette couche étant décrite par exemple dans le document US20040258929.

Dans un deuxième mode de réalisation, la couche poreuse est obtenue par le dépôt d'un sol de silice condensé (oligomères de silice) et densifié par des vapeurs de type NH3, cette couche étant décrite par exemple dans le document WO2005049757.

Dans un troisième mode de réalisation, la couche poreuse peut aussi être de type sol gel telle que comme décrite dans le document EP1329433. La couche poreuse peut aussi être obtenue avec d'autres agents porogènes connus : des micelles de molécules tensioactives cationiques en solution et, éventuellement, sous forme hydrolysée, ou de tensioactifs anioniques, non ioniques, ou des molécules amphiphiles, par exemple des copolymères blocs.

Comme un intercalaire de feuilletage, on peut choisir notamment une feuille de matière thermoplastique par exemple en polyuréthane (PU), en polyvinylbutyral (PVB), en éthylène vinylacétate (EVA), ou être en résine pluri ou mono-composants réticulable thermiquement (époxy, PU) ou aux ultraviolets (époxy, résine acrylique).

Par ailleurs lorsque le substrat porteur de la couche poreuse selon l'invention est un vitrage, le vitrage revêtu peut être traité thermiquement, à une température supérieure ou égale à 350°C de préférence supérieure ou égale à 500 voire à 600°C, pour une opération de (bombage) trempe. Il s'agit ainsi de préférence d'un verre trempé.

En effet, la couche poreuse selon l'invention a la capacité de supporter les traitements thermiques à haute température sans se fissurer et sans altération notable de ses propriétés optiques de sa durabilité ou de sa tenue hydrolytique. Il devient ainsi avantageux de pouvoir déposer la couche poreuse avant le traitement thermique du verre, notamment la trempe et le bombage/formage typiquement entre 500°C et 700°C, sans que cela pose de problème, car il est plus simple sur le plan industriel de faire le dépôt avant tout traitement thermique. On peut ainsi avoir une seule configuration d'antireflet, que le verre porteur soit ou non destiné à subir un traitement thermique.

Il n'est pas nécessaire d'effectuer auparavant un traitement thermique à plus basse température, typiquement entre 350°C et 450°C, pour densifier la couche et supprimer éventuellement l'agent porogène. La densification/formation de la couche poreuse peut ainsi se faire pendant la trempe ou le bombage.

D'autre part, l'invention a également pour objet un procédé de fabrication d'un substrat avec une couche poreuse de type sol-gel comportant les étapes successives suivantes :

- le mûrissement d'un sol de précurseur du matériau constitutif de la couche de type oxyde de silice, dopée ou non, notamment un composé hydrolysable tel qu'un halogénure ou un alcoxyde de silicium, dans un solvant notamment aqueux et/ou alcoolique,
- le mélange avec un agent porogène polymérique solide sous forme de particules et/ou un agent porogène liquide sous forme de nanogouttes en un premier liquide notamment huile, dispersées dans un deuxième liquide non miscible, notamment à base d'eau, les particules ou les nanogouttes étant de préférence de taille (plus petite et/ou plus grande dimension caractéristique) supérieure ou égale à 20 nm, notamment entre 40 et 100 nm,
- le dépôt sur le substrat,
- la condensation du précurseur autour de l'agent porogène,
- un traitement thermique, notamment une trempe et/ou un bombage/formage, à au moins 500°C, voire à au moins 600°C pendant une durée inférieure ou égale à 15 minutes, de préférence à 5 minutes.

L'agent porogène solide peut comprendre de manière avantageuse des billes de préférence polymériques notamment de type PMMA, copolymère méthyl méthacrylate/acide acrylique, polystyrène.

L'agent porogène liquide sous forme de nanogouttes peut comprendre de manière avantageuse les huiles déjà précitées.

Le traitement thermique peut ainsi incorporer l'étape d'élimination de l'agent porogène et achever la condensation pour la densifier la couche.

Le dépôt sur le substrat peut être réalisé par pulvérisation, par immersion et tirage à partir du sol de silice (ou « dip coating »), par centrifugation (ou « spin coating »), par coulée (« flow-coating »), par rouleau (« roll coating »).

Le procédé peut en outre comprendre, l'élimination de solvant(s), à une température inférieure ou égale à 120°C, 100°C.

En première variante, utile en particulier dans le cas de substrat plastique ou en verre (en particulier déjà trempé) et/ou avec un sol hybride, l'élimination dudit agent porogène choisi polymérique se fait par ajout d'un solvant extracteur du polymère, par exemple un THF dans le cas du PMMA, et la densification par un traitement UV par exemple pour un sol de silice hybride avec des fonctions réticulables UV (méthacrylate, vinyle, acrylate...).

En deuxième variante, utile dans le cas de substrat plastique et/ou verre (en particulier déjà trempé), le sol précurseur du matériau constitutif de la couche est un silicate de lithium, sodium ou potassium par exemple déposé par coulée ou « flow coating ». Dans le cas de substrat plastique (ou verre), l'élimination dudit agent porogène choisi polymérique se fait par ajout d'un solvant extracteur du polymère, par exemple un THF dans le cas du PMMA, et la densification se fait par un séchage infrarouge éventuellement sous air pulsé, à une température inférieure ou égale à 100°, par exemple 80°C.

Dans le cas d'un substrat verre, l'élimination dudit agent porogène choisi polymérique et la densification peut être réalisée à partir de 350°C.

Les détails et caractéristiques avantageuses de l'invention vont maintenant ressortir des exemples suivants non limitatifs, à l'aide des figures :

- les figures 1 à 4ter sont des images de microscopie électronique à balayage en coupe transverse ou en vue de dessus de couches poreuses conformément à l'invention,
- les figures 5 à 7 illustrent des graphes représentant les spectres en transmission de différents substrats nus ou revêtus de la couche poreuse selon les différents exemples de l'invention ou selon des exemples comparatifs,
- les figures 8 à 10 illustrent trois modules solaires intégrant un substrat revêtu d'une couche poreuse selon l'invention
- la figure 11 illustre un vitrage feuilleté teinté lumineux intégrant un substrat revêtu d'une couche poreuse selon l'invention,
- la figure 12 illustre le facteur de transmission en fonction de l'angle d'un dispositif électroluminescent organique dont le substrat est nu

ou revêtu sur sa face externe d'une couche poreuse selon l'invention.

EXEMPLES DE FABRICATION

• SERIE N°1

On découpe des échantillons de 10 cm x 10 cm d'un verre float verre clair silico-sodocalcique extraclair de 2,1 mm d'épaisseur, tel que le verre DIAMANT commercialisé par SAINT-GOBAIN GLASS. Ces échantillons sont lavés avec une solution de RBS, rincés, séchés et soumis à un traitement UV ozone pendant 45 min.

Chacun de ces échantillons est destiné à recevoir une couche poreuse selon l'invention sur la face étain ou sur la face bain. Le verre float peut être muni d'une sous-couche barrière aux alcalins par exemple type $SiO_2$, SiOC, SiNx, d'épaisseurs de l'ordre de 50 à 100 nm en ajustant éventuellement le choix des épaisseurs et des indices.

Le procédé de formation de la couche poreuse est décrit ci après.

La première étape de ce procédé consiste à préparer la composition liquide de traitement appelée par la suite « sol ».

Le sol est obtenu en mélangeant 20,8 g de tétraéthylorthosilicate, 18,4 g d'éthanol absolu, 7,2 g d'une solution aqueuse de pH = 2,5 acidifiée à l'aide de HCl. Le rapport molaire correspondant est 1 :4 :4. Cette composition est mélangée de préférence pendant quatre heures afin d'obtenir une hydrolyse complète du précurseur alkoxyde.

La deuxième étape de ce procédé consiste à mélanger au sol de silice obtenu précédemment l'agent porogène, à savoir des billes polymériques submicroniques, en proportions diverses et de différentes natures suivant les échantillons.

Dans une première configuration (essais 1 à 4), on incorpore des billes de PMMA dispersées dans de l'éthanol (20 % en poids). Différentes quantités de billes sont ajoutées pour obtenir une large gamme d'indices de réfraction. Un taux donné d'éthanol est privilégié en fonction de l'épaisseur de couches souhaitée. Ces billes ont un diamètre moyen total de 80 nm $\pm$ 10 nm mesurés par diffusion dynamique de la lumière (« Dynamic Light Scattering » en anglais) avec l'appareil Malvern Nano ZS.

Dans une deuxième configuration (essais 5 à 6), on incorpore le sol de silice dans une dispersion polymérique comportant des billes de copolymère méthyl méthacrylate/acide acrylique dispersées dans de l'eau (16% en poids, à pH = 4). Ces billes ont un diamètre moyen total de 75 nm $\pm$ 30 nm mesurés par diffusion dynamique de la lumière avec l'appareil Malvern Nano ZS.

La troisième étape est le dépôt du mélange de préférence préalablement filtré à 0,45 $\mu$m. Le dépôt se fait par spin coating sur une première face du verre, côté étain ou bain. La vitesse de rotation est par exemple égale à 1000 tours par minute.

D'autres techniques de dépôt équivalentes sont le dip coating, la pulvérisation, l'enduction laminaire, le roll coating, le flow coating.

La quatrième étape correspond à un traitement thermique.

Ainsi, une première partie des échantillons 1 à 6 est chauffée à 450°C pendant 3 heures pour éliminer les billes et densifier la couche et éliminer le ou les solvants. De préférence, on peut prévoir après le dépôt du sol une étape préalable d'élimination des solvants à 100°C pendant 1 heure par exemple pour réduire le risque d'apparition de craquelures suite à un chauffage trop brutal.

Une deuxième partie des échantillons 1 à 6 sont soumis au traitement de trempe à 640°C pendant 10 minutes permettant d'éliminer les billes et densifier la couche et d'obtenir un verre trempé. De préférence on peut prévoir après le dépôt du sol une étape préalable d'élimination des solvants à 100°C pendant 1 heure par exemple pour réduire le risque d'apparition de craquelures suite à un chauffage trop brutal.

Une cinquième étape facultative consiste à rajouter une surcouche. Ainsi une partie des échantillons 1 à 6 est fonctionnalisée avec du perfluorosilane $CF_3$-$(CF_2)_7$-$CH_2$-$CH_2$-Si-$(OH)_3$ - selon la procédure Aquacontrol® décrite dans la demande de brevet EP799873 - pour renforcer encore la tenue hydrolytique, en particulier en vue d'applications en extérieur ou en atmosphère humide.

Dans le cas d'un substrat plastique, seule la quatrième étape est modifiée : on élimine les billes par un solvant ad hoc, il reste nécessaire de faire un traitement thermique à 80°C pour densifier la couche et/ou un traitement UV.

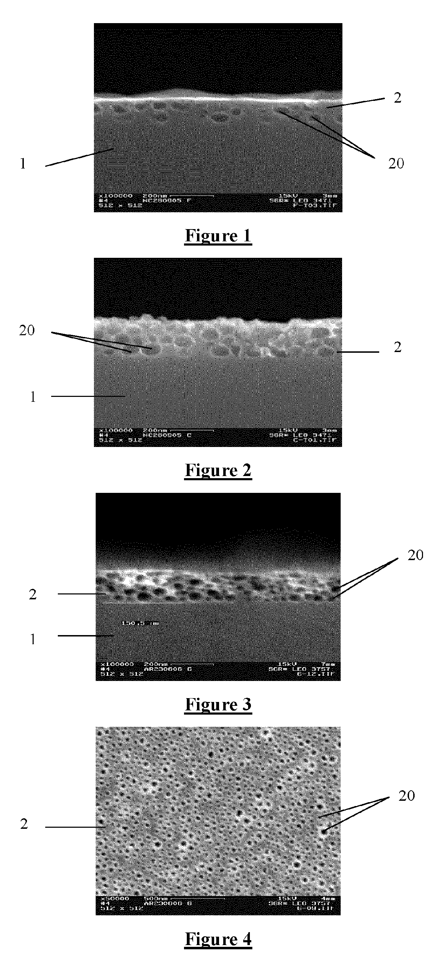

Les figures 1 et 2 montrent des images de microscopie électronique à balayage en coupe transverse plane des échantillons 2 et 3.

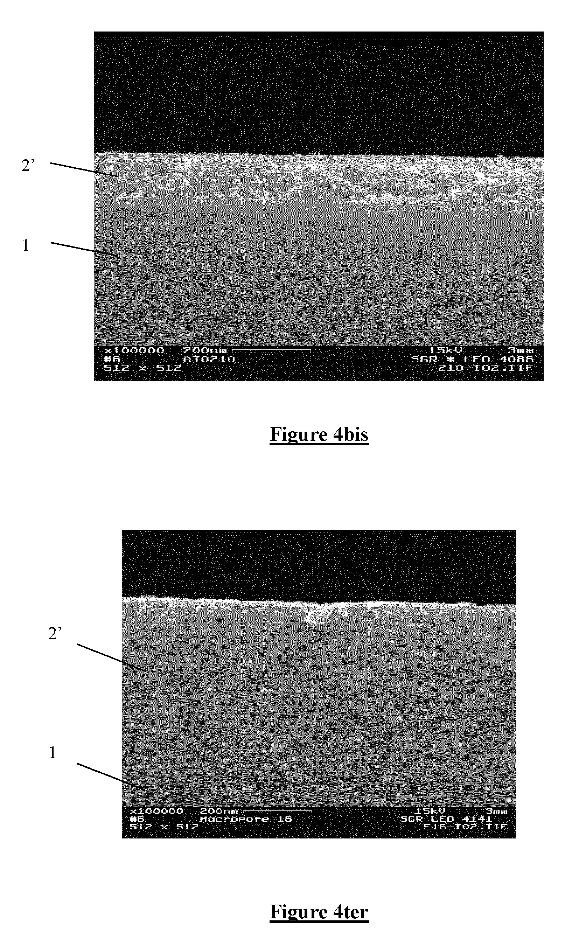

Les figures 3 et 4 montrent respectivement des images de microscopie électronique à balayage en coupe transverse plane et en vue de dessous de l'échantillon 5.

Pour tous les échantillons, on constate que la couche poreuse 2 présente des pores 20 bien individualisés et répartis de façon homogène dans toute son épaisseur, depuis l'interface avec le substrat en verre 1 jusqu'à l'interface avec l'air.

La surface de la couche poreuse 2 est remarquablement lisse du fait de l'élimination des billes polymériques sans création de fissures. Le flou est inférieur à 0,5%.

En utilisant les billes de PMMA, les pores de la couche poreuse ont une taille entre 50 et 70 nm, ce qui est proche de la taille de ces billes.

En utilisant les billes de copolymères de méthyl méthacrylate/acide acrylique, les pores de la couche poreuse ont une taille entre 30 et 70 nm reproduisant sensiblement la dispersion en taille de ces billes.

On consigne dans le tableau 1 ci-après différentes caractéristiques des couches des essais 1 à 6.

Tableau 1

| Essais N° | Volume de sol (μl) | Volume de solution à billes (μl) | % volume des billes | solvant (μl) | e (nm) |
|---|---|---|---|---|---|
| 1 | 200 | 260 | 55,6 | 2500 | 100 |
| 2 | 400 | 160 | 33,3 | 2500 | 130 |
| 3 | 200 | 360 | 68,9 | 2500 | 150 |
| 4 | 1000 | 600 | 55,6 | 400 | 800 |
| 5 | 600 | 260 | 62,2 | 2500 | 150 |
| 6 | 600 | 75 | 42,2 | 2500 | 120 |

Les épaisseurs des couches sont mesurées à partir des clichés MEB.

On pourrait choisir un autre précurseur notamment un silicate de sodium, de lithium ou de potassium, de 5 à 30% en solution dans l'eau.

Ainsi, en variante, dans le cas d'un substrat plastique ou verre, on choisit comme liant un silicate de potassium de sodium ou de lithium, on élimine les billes soit par un solvant ad hoc extracteur du polymère, par exemple un THF dans le cas du PMMA suivi d'un séchage à 80°C par exemple par infrarouge sous air pulsé, soit par un traitement thermique à partir de 350°C pendant au moins une heure pour éliminer les billes.

• SERIE N°2

Des échantillons de verre DIAMANT sont préparés comme dans la série n°1.

Un sol de silice est élaboré par hydrolyse de tétraéthylorthosilicate (TEOS) dans de l'eau acidifiée avec de l'acide chlorhydrique à pH = 2,5. La concentration massique de TEOS dans la formulation est de 40%. Le sol est hydrolysé sous agitation vigoureuse pendant 90 minutes (la solution initialement trouble devient limpide).

L'agent porogène solide utilisé est une des billes acryliques en suspension dans l'eau (extrait sec de 40%, pH = 5). Ces billes ont un diamètre moyen total de 70 nm $\pm$ 20 nm mesuré par diffusion dynamique de la lumière avec l'appareil Malvern Nano ZS.

Après incorporation de l'agent porogène, la formulation est diluée avec de l'eau acidifiée avec de l'acide chlorhydrique (pH = 2,5) pour ajuster l'épaisseur.

Dans un autre mode de réalisation, un précurseur d'alumine est ajouté à la formulation dans le but de doper la silice. Ce précurseur est l'acétylacétonate d'aluminium ou Al(acac). Il est introduit à raison de 5% molaire en remplacement du silicium. Pratiquement, l'Al(acac) est dissout dans l'eau de dilution avant ajout dans le sol. L'agent porogène est ajouté en dernier dans la formulation.

Les différentes formulations sont déposées par spin-coating à 2000 tours/min. Les échantillons sont ensuite directement traités thermiquement pendant 3 min à 700°C.

Les détails des différents essais sont donnés dans le tableau 2.

Tableau 2

| Essais N° | Volume de sol (µl) | Volume de solution à billes (µl) | % volume des billes | Masse d'Al(acac) (mg) | solvant (µl) |
|---|---|---|---|---|---|
| 7 | 3230 | 570 | 55% | 0 | 6200 |
| 8 | 3090 | 570 | 55% | 31 | 6340 |

Les couches ont une épaisseur de 110 nm environ, et des pores d'environ 70 nm (observations au MEB).

• SERIE N°3

Dans cette troisième série, seul l'agent porogène est différent de celui de la série n°2. Il s'agit d'une nanoémulsion d'huile paraffine dans l'eau (16.5% massique). La taille des gouttes d'huile est de 32 nm $\pm$ 10 nm mesurée par diffusion dynamique de la lumière avec l'appareil Malvern Nano ZS.
On utilise un sol de silice formulé dans l'eau pour éviter de déstabiliser l'émulsion.
Comme dans les exemples 6 et 7, il est possible de doper la silice avec de l'alumine.
Les couches sont déposées puis traitées thermiquement dans les mêmes conditions que la série n°2.
Les détails des différents essais sont donnés dans le tableau 3.

Tableau 3

| Essais N° | Volume de sol (µl) | Volume de solution à nanogouttes (µl) | % volume des nanogouttes | Masse d'Al(acac) (mg) | solvant (µl) |
|---|---|---|---|---|---|
| 9 | 3230 | 1380 | 55% | 0 | 5390 |
| 10 | 3090 | 1380 | 55% | 31 | 5530 |

Les couches ont une épaisseur de 110 nm environ et des pores de 30 nm (observations au MEB).
Les figures 4bis et 4ter montrent respectivement des images de microscopie électronique à balayage en coupe transverse plane du type de la série n°3.
Pour la figure 4bis, il s'agit d'une couche poreuse mince 2' sur verre 1 et pour la figure 4ter, d'une couche poreuse épaisse 2' sur verre 1.

PROPRIETES OPTIQUES

On consigne dans le tableau 4 ci-après l'indice de réfraction dans le visible des couches 1 à 10.

Tableau 4

| Essais N° | e (nm) | n |
|---|---|---|
| 1 | 100 | 1,2 |
| 2 | 130 | 1,3 |
| 3 | 150 | 1,14 |
| 4 | 800 | 1,2 |
| 5 | 150 | 1,17 |
| 6 | 120 | 1,26 |
| 7 | 110 | 1,25 |
| 8 | 120 | 1,27 |
| 9 | 100 | 1,27 |
| 10 | 110 | 1,30 |

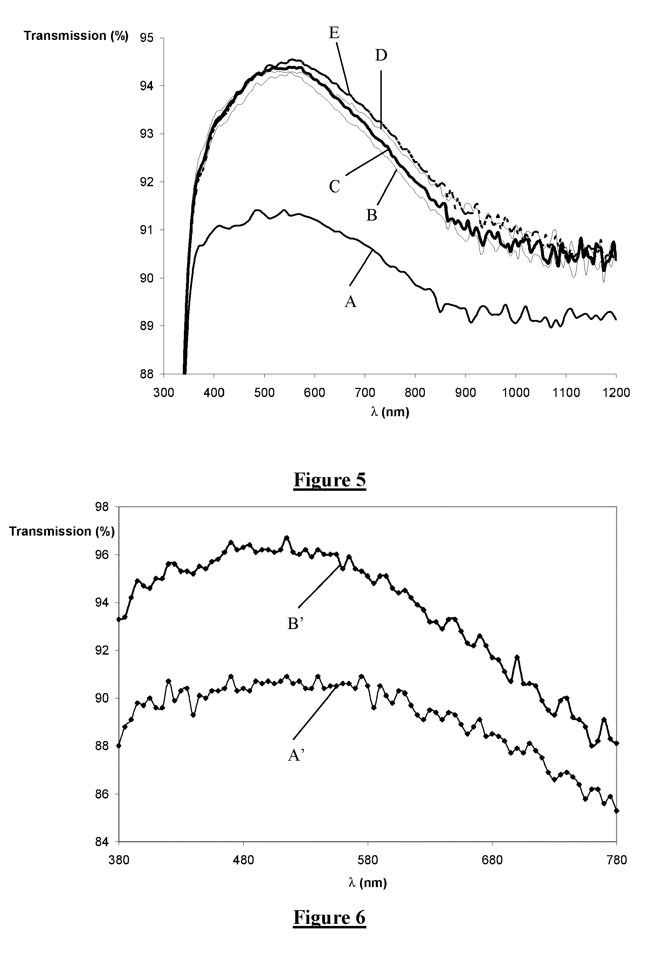

La figure 5 montre les profils de transmission T entre 400 et 1200 nm pour un verre extraclair type diamant nu (courbe A), et pour des échantillons de l'essai n°1:

- un premier traité thermiquement à 450°C sans greffage fluorosilane (courbe B),
- un deuxième traité thermiquement à 640°C et greffé fluorosilane (courbe C),
- un troisième traité thermiquement à 640°C sans greffage fluorosilane (courbe D),
- un quatrième non traité thermiquement à 640°C et greffé fluorosilane (courbe E).

On observe pour les échantillons de l'essai n°1 une augmentation de 3 ou 4% de la transmission lumineuse dans le visible et de 2% dans les proches infrarouges par rapport au verre nu comparatif. Ni le greffage ni le traitement à 640°C n'affecte les propriétés optiques.

Dans toute la gamme 400 - 1200 nm, la transmission T est supérieure à 90%, notamment supérieure ou égale à 93% entre 400 et 700 nm.

La réflexion R est par ailleurs sensiblement constante, autour de 5 à 5,5% entre 400 et 700 nm et autour de 8% entre 700 et 1200 nm.

On obtient des résultats similaires avec les échantillons des essais n°2 à 10.

En variante, on a déposé des couches selon les procédés précédemment décrits pour les séries n°1 à n°3 en remplaçant le verre extraclair DIAMANT par un verre clair de type PLANILUX de 2,1 mm d'épaisseur.

La figure 6 montre ainsi les profils de transmission T entre 300 et 1200 nm pour un verre Planilux nu (courbe A'), et pour un deuxième échantillon avec une couche poreuse sur chaque face (courbe B'), chaque couche étant traitée à 450°C.

Cet échantillon est pour une application antireflet classique : des vitrines de magasins, des vitrages à protéger, des tableaux, des comptoirs.

On observe une augmentation de 5 à 6% de la transmission T dans le visible pour l'échantillon « bicouche » avec une transmission de 96% à 550 nm. La réflexion R est par ailleurs sensiblement constante, autour de 2 - 2,5%, entre 400 et 700 nm, notamment 1,9 à 550 nm, contre environ 5% avec une seule couche.

TESTS

Les échantillons 1 à 6 subissent différents tests détaillés comme suit.

Un premier test consistant à évaluer la durabilité, est souvent dénommé en anglais « climate test » selon la norme IEC61250. Les couches subissent 20 cycles thermiques de - 40°C à + 80°C.

Comme deuxième test, ces couches subissent un test de résistance à l'humidité connu sous le terme anglais de « damp heat », et consistant à les laisser pendant 1000 heures à 85°C dans une enceinte dont l'atmosphère a un taux d'humidité relative contrôlé de 85 % (norme IEC 61215).

Comme troisième test, on fait subir à ces couches le test de résistance chimique basique connu sous le terme de test de brouillard salin neutre ou BSN, selon la norme DIN 50021. Le protocole est le suivant : les couches sont soumises à un brouillard aqueux contenant 50 g/l de NaCl avec un pH de 7 et une température de 35°C pendant 500 heures.

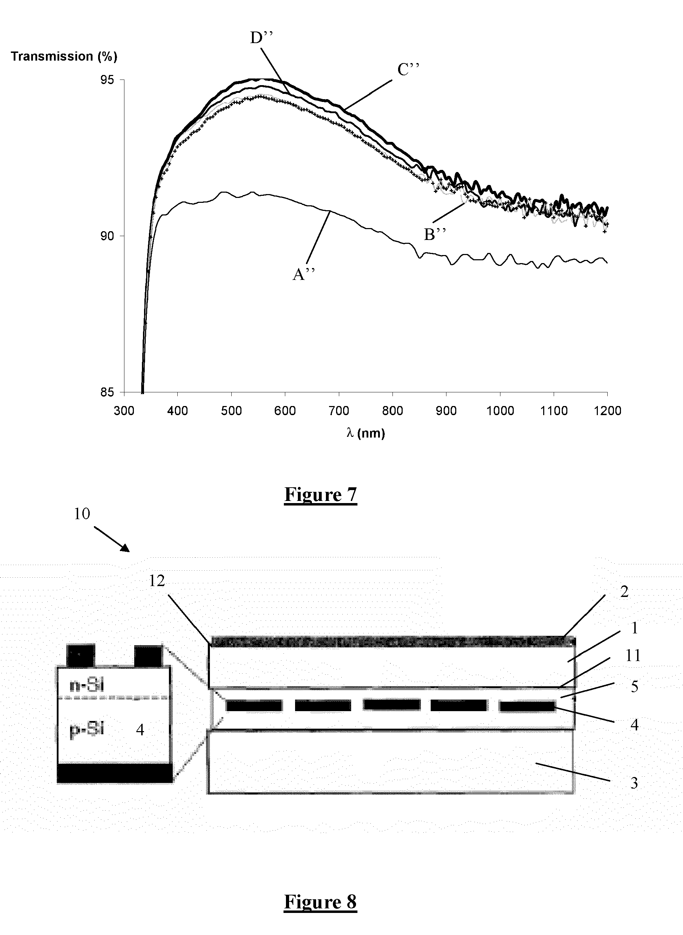

La figure 7 montre ainsi les profils de transmission lumineuse entre 300 et 1200 nm pour un verre DIAMANT nu (courbe A") et pour des échantillons de la série 1 suivants :

- échantillon traité thermiquement à 640°C avec ou sans greffage n'ayant subi aucun test (courbe B"),
- échantillon traité thermiquement à 640°C avec ou sans greffage et ayant subi le premier test (courbe C"),
- échantillon traité thermiquement à 640°C avec ou sans greffage et ayant subi le deuxième test (courbe D"),
- échantillon traité thermiquement à 640°C et ayant subi le troisième test (courbe E").

On observe que la transmission lumineuse est inchangée tout comme la réflexion lumineuse et l'indice de réfraction.

Les échantillons 7 à 10 subissent les tests suivants :

- le test damp heat défini ci-dessus,
- un test de résistance à l'abrasion (Opel) selon la norme DIN 61200.

Le tableau 5 résume les valeurs de gain énergétique apporté par la couche antireflet pour un module photovoltaïque à base de silicium avant et après ces deux tests.

Le gain énergétique est défini comme suit :

$$G = \frac{I_{AR} - I_S}{I_S}$$

$I_{AR}$ et $I_S$ sont respectivement les densités de courant obtenues avec et sans la couche antireflet.

La densité de courant est définie comme suit :

$$I = \int_{300}^{1300} D(\lambda)T(\lambda)R_{cellule}(\lambda)$$

Avec

$D(\lambda)$ : spectre d'émission solaire

$T(\lambda)$ : transmission spectrale du verre

$R_{cellule}(\lambda)$ : efficacité quantique de la cellule photovoltaïque à une longueur d'onde $\lambda$. Ici nous avons considéré une cellule en silicium.

Tableau 5

| N° essais | Gain à t = 0 | Gain après 1000h 'damp heat' test | Gain après 5000 cycles Opel |
|---|---|---|---|
| 7 | 2,9% | 1,7% | 2,2% |
| 8 | 2,9% | 2,9% | 0,7% |
| 9 | 3,2% | 1,5% | 2,8% |
| 10 | 3,2% | 2,7% | 1,9% |

Ces tests mettent en valeur l'effet positif du dopage à l'alumine vis-à-vis de la tenue hydrolytique. Ce dopage entraîne une baisse de la tenue mécanique, moins importante dans le cas de l'agent porogène de type nanoémulsion d'huile.

Les procédés décrits ci-dessus peuvent aussi être modifiés comme suit.

On pourrait aussi incorporer d'autres agents porogènes connus avec les billes, par exemple des micelles de molécules tensioactives cationiques en solution et, éventuellement, sous forme hydrolysée, ou de tensioactifs anioniques, non ioniques, ou des molécules amphiphiles, par exemple des copolymères blocs. De tels agents génèrent des pores sous forme de canaux de petite largeur ou des pores plus ou moins ronds de petite taille entre 2 et 5 nm. Le tensioactif cationique peut être le bromure de cétyltriméthylammonium, le précurseur du matériau est en solution sous sa forme résultant d'une hydrolyse en milieu acide:$Si(OH)_4$ et le rapport molaire tensioactif:Si est compris entre $10^{-4}$ et 0,5.

En variante, on peut choisir de revêtir la couche poreuse d'une face texturée avec un relief macroscopique, notamment un verre extraclair laminé et imprimé tel que le verre ALBARINO de la société SAINT GOBAIN GLASS ou encore un verre clair type PLANILUX de la société SAINT GOBAIN GLASS.

En autre variante, on peut aussi prévoir un empilement de couches poreuses de préférence de plus en plus poreuses avec l'épaisseur croissante.

## MODULE SOLAIRE

On choisit préférentiellement les échantillons 1, 6 et 10 en tant que verre extérieur d'un module solaire.

Le module 10 montré en figure 8 est constitué de la façon suivante : le verre 1 muni de la couche poreuse antireflet 2 sur sa face extérieure 12 (côté air) est associé par sa face intérieure 11 à un verre 3 dit verre « intérieur ». Ce verre intérieur 3 est en verre trempé, de 2,1 mm d'épaisseur, et clair ou extra-clair.

Plus précisément, les cellules photovoltaïques 4 sont placées entre les deux verres 1, 3 puis on vient couler dans l'entre-verre un polymère durcissable à base de polyuréthane 5 conformément à l'enseignement du brevet EP 0 739 042.

Chaque cellule photovoltaïque 4 est constituée, de façon connue, à partir de « wafers » de silicium formant une jonction p/n et des contacts électriques avant et arrière imprimés. Les cellules photovoltaïques de silicium peuvent être remplacées par des cellules solaires utilisant d'autres semiconducteurs (comme CIS, CdTe, a-Si, GaAs, GaInP).

A titre de comparaison, on a monté un module solaire identique au précédent, mais avec un verre extérieur en verre extra-clair ne comportant pas la couche poreuse antireflet selon l'invention.

L'augmentation du rendement, exprimée en densité de courant intégrée, est d'environ 2,9% par rapport au module classique.

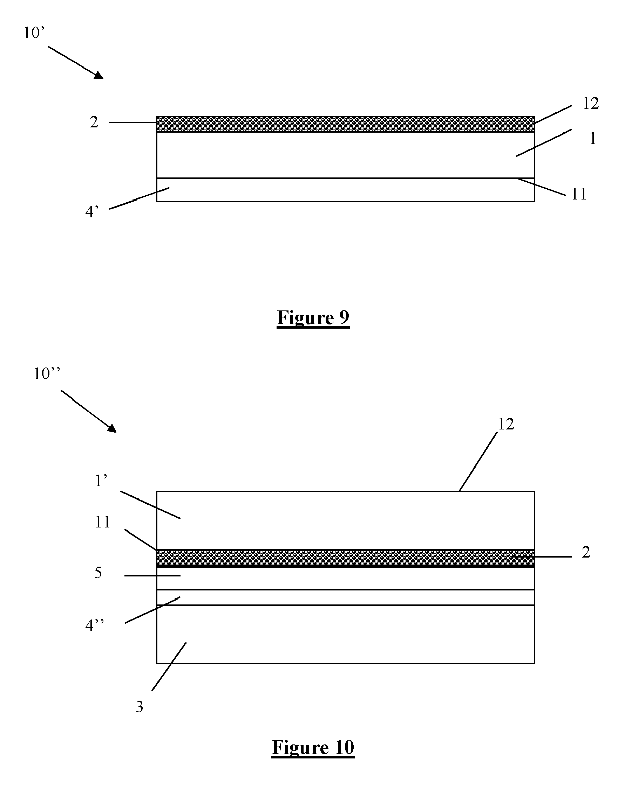

Dans une première variante montrée en figure 9, le module 10' comprend le verre 1 avec sur sa face extérieure 12 la couche poreuse 2 et sur sa face intérieure une ou des cellules photovoltaïques 4' à couche mince par exemple de type a-Si,CdTe, GaAs ou GaInP.

Plus précisément, et de façon conventionnelle, chaque cellule photovoltaïque comprend l'empilement suivant :

- une couche transparente électroconductrice (connue sous le nom de « TCO » en anglais),
- la couche active type a-Si (mono ou multicouche),
- un réflecteur métallique par exemple en argent ou aluminium.

Dans une deuxième variante montrée en figure 10, les cellules photovoltaïques 4", sont de type CIS et sur du verre 3.

Les cellules photovoltaïques 4" sont feuilletées avec un intercalaire de feuilletage 5, par exemple en EVA au premier verre 1'. Comme premier verre 1, on choisit de préférence un verre coloré 1' avec sur sa face interne de feuilletage 11 la couche poreuse bas indice 2 de préférence des échantillons 3, 4 ou 5, avec un indice le plus bas possible et une épaisseur à partir de 150 nm.

Ce type de module par exemple sur une façade conserve la couleur du verre coloré.

Eventuellement, une couche antireflet externe notamment telle que la couche poreuse des échantillons 1, 6 à 10 peut être rajoutée.

En variante, on forme un simple vitrage feuilleté, la couche poreuse formant un séparateur optique.

STRUCTURE FEUILLETEE LUMINEUSE

On réalise un toit lumineux 100 pour automobile comprenant :

- un premier substrat transparent et plan 1, d'indice optique n1 égal à 1,5 environ, par exemple un verre clair ou extraclair,
- un deuxième substrat plan teinté dans la masse 1", notamment un verre teinté, tel que le verre VG10,
- un intercalaire de feuilletage 5, entre les premier et deuxième substrats, par exemple un PVB,
- une couche poreuse 2" discontinue formant séparateur optique, déposée sur le premier verre, la couche 2" étant d'indice optique n2 par exemple égale à 1,1 et d'épaisseur 400 nm,
- une source d'éclairage par la tranche du premier substrat, sous forme de diodes électroluminescentes 6 de préférence logées dans une rainure du premier verre 1,
- un réseau rétrodiffusant interne 7 entre la couche poreuse et le premier substrat, sous forme de motifs de dimensions adaptées en fonction de l'éclairage souhaité.

Pour la couche poreuse on peut choisir l'une des couches des exemples précités en ajustant l'épaisseur si nécessaire.

DISPOSITIF « OLED »

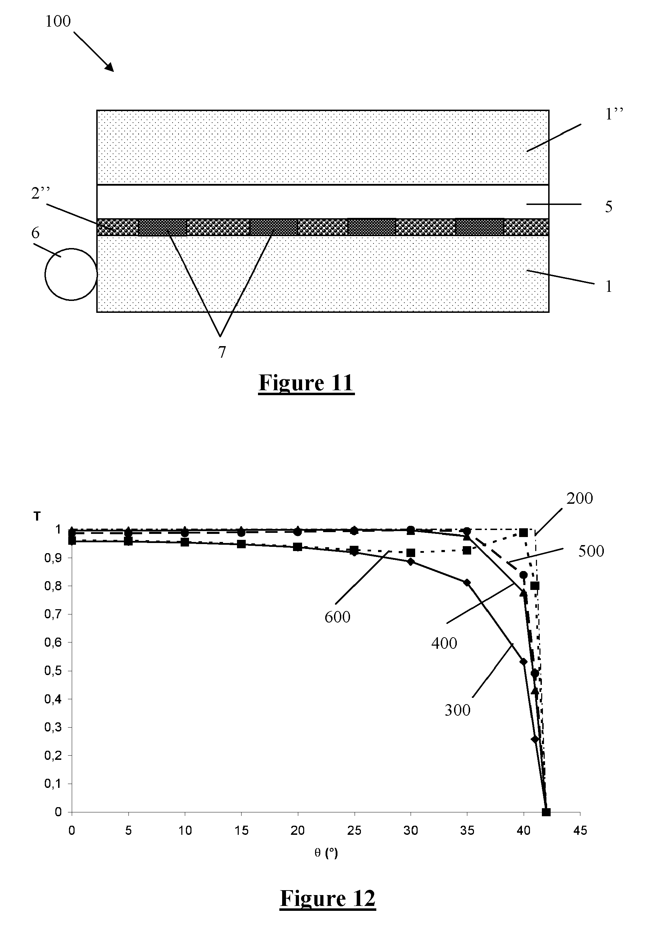

La figure 12 illustre le facteur de transmission en fonction l'angle d'un dispositif électroluminescent organique intégrant un substrat nu ou revêtu sur sa face externe d'une couche poreuse obtenue avec un agent porogène de type nanoparticules ou nanogouttes conformément à l'invention, par exemple par les procédés de fabrications déjà décrits pour les exemples 1 à 10.

Le profil de la courbe 200 correspond au cas idéal où l'ensemble des faisceaux lumineux, quelle que soit leur incidence à l'interface entre le verre et l'air, est extrait du verre.

La courbe 300 correspond à un verre nu.

La courbe 400 correspond à un verre revêtu de la couche poreuse pour une optimisation de l'extraction réalisée à 0°.

La courbe 500 correspond à un verre revêtu de la couche poreuse pour une optimisation de l'extraction réalisée à 32°.

La courbe 600 correspond à un verre revêtu de la couche poreuse pour une optimisation de l'extraction réalisée à 40°.

Par ailleurs, le rapport de forme normalisée A défini par la relation suivante :

$$A = \frac{\int T(\theta)\, d\theta}{\int R(\theta)\, d\theta},$$

dans laquelle

T(θ) correspond à la transmission de la lumière en fonction de l'angle d'incidence du faisceau lumineux θ,

R(θ) est un profil rectangulaire en fonction de l'angle d'incidence du faisceau lumineux θ, compris entre 0° et l'angle limite de réfraction entre le verre et l'air, la hauteur de R (x) étant normalisée à 1.

Le rapport de forme A évaluant donc l'écart à l'idéalité de la configuration, est reporté en tableau 6. Pour chaque optimisation d'extraction à un angle donné, on obtient un choix préféré d'indice optique et d'épaisseur.

Tableau 6

| Angle d'optimisation | n | e(nm) | Rapport de forme A |
|---|---|---|---|
| Verre nu (comparatif) | | | 0,875 |
| 0° (verre revêtu) | 1,22 | 135 | 0,965 |
| 32° (verre revêtu) | 1,19 | 160 | 0,968 |
| 40° (verre revêtu) | 1,1 | 280 | 0,941 |

On observe une augmentation notable du rapport de forme avec la couche poreuse.

**Revendications**

1.  Procédé de fabrication d'une couche poreuse de type sol-gel (2, 2') sur un substrat verrier (1, 1') qui comprend les étapes successives suivantes :

    - le mûrissement d'un sol précurseur du matériau constitutif de la couche de type oxyde de silice, dopée ou non, notamment un composé hydrolysable, dans un solvant notamment aqueux,
    - le mélange avec un agent porogène et solide sous forme de particules polymériques, et/ou sous forme de nanogouttes en un premier liquide notamment huile, dispersées dans un deuxième liquide non miscible, notamment à base d'eau, les particules et/ou les nanogouttes étant de préférence de taille supérieure ou égale à 20 nm et étant de préférence de taille inférieure à 100 nm,
    - le dépôt sur le substrat,
    - la condensation du précurseur autour de l'agent porogène,
    - un traitement thermique, notamment une trempe et/ou un bombage/formage, à au moins 500°C pendant une durée inférieure ou égale à 5 minutes.

2.  Procédé de fabrication d'une couche poreuse sol-gel (2, 2') sur un substrat verrier selon la revendication précédente **caractérisé en ce que** ledit traitement thermique est à au moins 600°C pendant une durée inférieure ou égale à 5 minutes.

3.  Procédé de fabrication d'une couche poreuse sol-gel (2, 2') sur un substrat verrier selon l'une des revendications précédentes **caractérisé en ce qu'**il comprend l'élimination du solvant, notamment aqueux, à une température inférieure ou égale à 120°C, voire à 100°C.

4.  Procédé de fabrication d'une couche poreuse sol-gel (2, 2') sur un substrat verrier selon l'une des revendications précédentes **caractérisé en ce que** l'agent porogène solide et sous forme de particules polymériques, notamment sous forme de billes polymériques monocomposant ou bicomposant, est dans une dispersion colloïdale ou est sous forme d'une poudre redispersable dans un solvant, notamment aqueux, correspondant au solvant du sol, notamment aqueux.

5.  Procédé de fabrication d'une couche poreuse sol-gel (2, 2') sur un substrat verrier selon l'une des revendications précédentes **caractérisé en ce que** l'agent porogène solide et sous forme de particules polymériques, notamment sous forme de billes polymériques monocomposant ou bicomposant, est en l'un des polymères suivants :

    - en polyméthacrylate de méthyle,
    - en copolymères méthyl (méth)acrylate/acide (méth)acrylique,
    - en polymères polycarbonates, polyester, polystyrène,
    ou d'une combinaison de plusieurs de ces matériaux.

**6.** Procédé de fabrication d'une couche poreuse sol-gel (2, 2') sur un substrat verrier selon l'une des revendications précédentes **caractérisé en ce que** le traitement thermique incorpore l'étape d'élimination de l'agent porogène et achève la condensation pour densifier la couche.

**7.** Procédé de fabrication d'une couche poreuse sol-gel (2, 2') sur un substrat verrier selon l'une des revendications précédentes **caractérisé en ce que** ledit procédé est exempt d'un traitement thermique à plus basse température pour densifier la couche.

**8.** Substrat revêtu (10, 10', 10", 100) au moins partiellement d'au moins une couche poreuse (2, 2') essentiellement minérale de type sol gel, **caractérisé en ce qu'**elle présente une série de pores (20) fermés avec au moins la plus petite dimension caractéristique qui est, en moyenne, supérieure ou égale à 20 nm et de préférence inférieure ou égale à 100 nm.

**9.** Substrat revêtu (10, 10', 10", 100) selon la revendication précédente **caractérisé en ce que** les pores ont une forme définie, de préférence sensiblement sphérique ou ovale.

**10.** Substrat revêtu (10, 10', 10", 100) selon l'une quelconque des revendications 8 ou 9, **caractérisé en ce que** la couche poreuse (2, 2') est essentiellement à base de silice, hybride ou minérale, de préférence dopée par l'un au moins des dopants suivants : Al, Zr, B, Sn, Zn.

**11.** Substrat revêtu (10, 10', 10", 100) selon l'une quelconque des revendications 8 à 10, **caractérisé en ce que** l'épaisseur de la couche poreuse (2, 2'), monocouche ou multicouche, est comprise entre 100 et 200 nm, notamment entre 100 et 150 nm.

**12.** Substrat revêtu (10, 10', 10", 100) selon l'une quelconque des revendications 8 à 11, **caractérisé en ce que** le substrat est plan et verrier, notamment un verre plan imprimé texturé, la face revêtue présentant un relief macroscopique par exemple des motifs de profondeur de l'ordre de fraction(s) du millimètre à quelques millimètres, notamment des pyramides.

**13.** Substrat revêtu (10, 10', 10", 100) selon l'une quelconque des revendications 8 à 12, **caractérisé en ce que** le substrat est un vitrage en verre silico-sodocalcique (1, 1') de préférence extraclair et le substrat revêtu présente une transmission du rayonnement supérieure ou égale à 91% à 600 nm et/ou à 550 nm et de préférence supérieure ou égale à 90% entre 400 et 1200 nm et/ou une réflexion du rayonnement lumineux inférieure ou égale à 7% à 600 nm et/ou à 550 nm.

**14.** Utilisation du substrat revêtu selon l'une quelconque des revendications 8 à 13, en tant que substrat extérieur (1) transparent d'un module solaire (10, 10') comprenant au moins une cellule photovoltaïque (4, 4', 4"), notamment du type Si, CIS, CdTe, a-Si, GaAs ou GaInP, la face revêtue (12) étant la face externe.

**15.** Module solaire (10, 10') comprenant au moins une cellule photovoltaïque (4, 4', 4"), notamment du type Si, CIS, CdTe, a-Si, GaAs ou GaInP, **caractérisé en ce qu'**il utilise en tant que substrat extérieur (1) le substrat revêtu selon l'une quelconque des revendications 8 à 13, la face revêtue (12) étant la face externe.

**16.** Module solaire (10") **caractérisé en ce qu'**il comporte :

- ledit substrat revêtu (1') selon l'une quelconque des revendications 8 à 13, substrat choisi plan et notamment en verre coloré (1'),
- et au moins une cellule solaire (4"), notamment du type Si, CIS, CdTe, a-Si, GaAs ou GaInP, qui est associée à un deuxième substrat plan (3), notamment en verre, et est feuilletée avec un intercalaire de feuilletage avec le substrat revêtu, la couche poreuse étant sur la face de feuilletage.

**17.** Vitrage multiple **caractérisé en ce qu'**il comporte :

- un substrat choisi plan et en verre, notamment coloré, revêtu selon l'une quelconque des revendications 8 à 13,
- un deuxième substrat plan, de préférence en verre, qui est feuilleté avec un intercalaire de feuilletage avec le substrat revêtu, la couche poreuse étant sur la face de feuilletage.

**Figure 1**

**Figure 2**

**Figure 3**

**Figure 4**

**Figure 4bis**

**Figure 4ter**

**Figure 5**

**Figure 6**

**Figure 7**

**Figure 8**

10'

2 — 12

1

11

4'

**Figure 9**

10''

12

1'

11

5

2

4''

3

**Figure 10**

**Figure 11**

**Figure 12**

# EP 2 423 171 A1

## RAPPORT DE RECHERCHE EUROPEENNE

Numéro de la demande

EP 11 18 7873

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CHANG DONG SOOK ET AL.: "Fabrication of uniformly nano-sized macroporous silica structure using templates", KEY ENGINEERING MATERIALS, vol. 317-318, août 2006 (2006-08), pages 729-732, XP009085304, * "Experimental Procedure"; Figure 3 *  ----- | 8 | INV. C03C17/00 C03C17/25 H01L31/00 B32B17/00 G02B6/00 B60Q3/02 |
| X | HSU ET AL: "Preparation and characterization of nanocrystalline porous TiO2/WO3 composite thin films", THIN SOLID FILMS, ELSEVIER-SEQUOIA S.A. LAUSANNE, CH, vol. 494, no. 1-2, 3 janvier 2006 (2006-01-03), pages 228-233, XP005172012, ISSN: 0040-6090 * "2. Experimental Procedures"; Figure 1, Figure 2(b) *  ----- | 8 | |
| X | EP 1 659 423 A (HITACHI LTD [JP]) 24 mai 2006 (2006-05-24) * alinéa [0040] - alinéa [0042]; revendications 1,4,15,16,18,19,37-42; figures 1,2; exemples; tableau 9 *  ----- | 8-17 | DOMAINES TECHNIQUES RECHERCHES (IPC)  C03C H01L B32B G02B B60Q |
| X | US 2006/046045 A1 (WANG WU-JING [TW] ET AL) 2 mars 2006 (2006-03-02) * alinéas [0007], [0026]; exemples *  ----- | 8-13 | |

-/--

Le présent rapport a été établi pour toutes les revendications

| Lieu de la recherche | Date d'achèvement de la recherche | Examinateur |
|---|---|---|
| Munich | 25 janvier 2012 | Munro, Brian |

Europäisches
Patentamt

European
Patent Office

Office européen
des brevets

# RAPPORT DE RECHERCHE EUROPEENNE

Numéro de la demande

EP 11 18 7873

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | SASAHARA K ET AL: "Macroporous and nanosized ceramic films prepared by modified sol-gel method with PMMA microsphere templates", JOURNAL OF THE EUROPEAN CERAMIC SOCIETY, ELSEVIER SCIENCE PUBLISHERS, BARKING, ESSEX, GB, vol. 24, no. 6, 2004, pages 1961-1967, XP004485500, ISSN: 0955-2219 * "2. Experimental"; Figure 3d * ----- | 1,4 | |
| X | CAO ET AL: "Fabrication of anatase titania inverse opal films using polystyrene templates", SUPERLATTICES AND MICROSTRUCTURES, ACADEMIC PRESS, LONDON, GB, vol. 40, no. 3, septembre 2006 (2006-09), pages 155-160, XP005624367, ISSN: 0749-6036 * le document en entier * ----- | 8 | |
| X | ZHANG ET AL: "Synthesize of porous TiO2 thin film of photocatalyst by charged microemulsion templating", MATERIALS CHEMISTRY AND PHYSICS, ELSEVIER, vol. 93, no. 2-3, 15 octobre 2005 (2005-10-15), pages 508-515, XP005129067, ISSN: 0254-0584 * "2. Experimental" et figures 2 et 8, et page 514 * ----- | 8,9 | DOMAINES TECHNIQUES RECHERCHES (IPC) |
| A | FR 2 874 007 A (ESSILOR INT [FR]) 10 février 2006 (2006-02-10) * le document en entier * ----- -/-- | 8-17 | |

Le présent rapport a été établi pour toutes les revendications

| Lieu de la recherche | Date d'achèvement de la recherche | Examinateur |
|---|---|---|
| Munich | 25 janvier 2012 | Munro, Brian |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

.............................................................................
& : membre de la même famille, document correspondant

EPO FORM 1503 03.82 (P04C02)

EP 2 423 171 A1

Europäisches
Patentamt
European
Patent Office
Office européen
des brevets

RAPPORT DE RECHERCHE EUROPEENNE

Numéro de la demande

EP 11 18 7873

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | EP 1 329 433 A (CT DE INVESTIGACIONES ENERGETI [ES]) 23 juillet 2003 (2003-07-23) * le document en entier * | 8-17 | |
| A | FAN H ET AL: "Self-assembled aerogel-like low dielectric constant films", JOURNAL OF NON-CRYSTALLINE SOLIDS, NORTH-HOLLAND PUBLISHING COMPANY, AMSTERDAM, NL, vol. 285, no. 1-3, juin 2001 (2001-06), pages 79-83, XP004242905, ISSN: 0022-3093 * le document en entier * | 8 | |
| X | ISKANDAR FERRY ET AL: "Optical band gap and ultralow dielectric constant materials prepared by a simple dip coating process", JOURNAL OF APPLIED PHYSICS, AMERICAN INSTITUTE OF PHYSICS. NEW YORK, US, vol. 93, no. 11, 1 juin 2003 (2003-06-01), pages 9237-9242, XP012058684, ISSN: 0021-8979 * abrégé, II. Experiment & fig. 4 * | 8-11 | |
| X | US 5 871 843 A (YONEDA TAKASHIGE [JP] ET AL) 16 février 1999 (1999-02-16) * colonne 7, ligne 24 - ligne 50; figures 1-5; exemples; tableau 2 * | 1,8-11, 14 | DOMAINES TECHNIQUES RECHERCHES (IPC) |
| X | JP 7 138046 A (CENTRAL GLASS CO LTD; NISSAN MOTOR) 30 mai 1995 (1995-05-30) * abrégé * * alinéa [0024] - alinéa [0028] * | 1 | |
| E | WO 2008/059171 A (SAINT GOBAIN [FR]; SCHIAVONI MICHELE [FR]; COUNIL GUILLAUME [FR]; HUIG) 22 mai 2008 (2008-05-22) * le document en entier * | 1-17 | |

Le présent rapport a été établi pour toutes les revendications

| Lieu de la recherche | Date d'achèvement de la recherche | Examinateur |
|---|---|---|
| Munich | 25 janvier 2012 | Munro, Brian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

26

Europäisches
Patentamt

European
Patent Office

Office européen
des brevets

Numéro de la demande

EP 11 18 7873

## REVENDICATIONS DONNANT LIEU AU PAIEMENT DE TAXES

La présente demande de brevet européen comportait lors de son dépôt les revendications dont le paiement était dû.

☐ Une partie seulement des taxes de revendication ayant été acquittée dans les délais prescrits, le présent rapport de recherche européenne a été établi pour les revendications pour lesquelles aucun paiement n'était dû ainsi que pour celles dont les taxes de revendication ont été acquittées, à savoir les revendication(s):

☐ Aucune taxe de revendication n'ayant été acquittée dans les délais prescrits, le présent rapport de recherche européenne a été établi pour les revendications pour lesquelles aucun paiement n'était dû.

## ABSENCE D'UNITE D'INVENTION

La division de la recherche estime que la présente demande de brevet européen ne satisfait pas à l'exigence relative à l'unité d'invention et concerne plusieurs inventions ou pluralités d'inventions, à savoir:

voir feuille supplémentaire B

☐ Toutes les nouvelles taxes de recherche ayant été acquittées dans les délais impartis, le présent rapport de recherche européenne a été établi pour toutes les revendications.

☒ Comme toutes les recherches portant sur les revendications qui s'y prêtaient ont pu être effectuées sans effort particulier justifiant une taxe additionnelle, la division de la recherche n'a sollicité le paiement d'aucune taxe de cette nature.

☐ Une partie seulement des nouvelles taxes de recherche ayant été acquittée dans les délais impartis, le présent rapport de recherche européenne a été établi pour les parties qui se rapportent aux inventions pour lesquelles les taxes de recherche ont été acquittées, à savoir les revendications:

☐ Aucune nouvelle taxe de recherche n'ayant été acquittée dans les délais impartis, le présent rapport de recherche européenne a été établi pour les parties de la demande de brevet européen qui se rapportent à l'invention mentionnée en premier lieu dans les revendications, à savoir les revendications:

☐ Le present rapport supplémentaire de recherche européenne a été établi pour les parties de la demande de brevet européen qui se rapportent a l'invention mentionée en premier lieu dans le revendications (Règle 164 (1) CBE)

Europäisches
Patentamt

European
Patent Office

Office européen
des brevets

**ABSENCE D'UNITÉ D'INVENTION**
**FEUILLE SUPPLÉMENTAIRE B**

Numéro de la demande

EP 11 18 7873

La division de la recherche estime que la présente demande de brevet européen ne satisfait pas à l'exigence relative à l'unité d'invention et concerne plusieurs inventions ou pluralités d'inventions, à savoir :

1. revendications: 1-7

    Procédé de fabrication d'une couche poreuse de type sol-gel sur un substrat verrier utilisant l'agent porogène solide sous formes de particules polymériques ou sous formes de nanogouettes avec traitement thermique à au moins 500°C pendant une durée inférieure ou égale à 5 minutes.Les raisons pour lesquelles la présente demande porte sur 2 inventions non liées entre elles de telle sorte qu'elles ne formeraient qu'un seul concept inventif général, comme le requiert l'article 82, sont les suivantes:
    L'état de la technique cité dans la rapport de recherche décrit des substrats revêtus des couches poreuse (D1-D10) et des procédés pour fabriquer les mêmes utilisant l'agents porogène sous forme des particules polymériques (D1, D2, D5-D7) ou sous forme des nanogouttes (D10).
    Les éléments suivants apparaissent donc comme les éléments techniques particuliers au sens de l'article 82 CBE:
    L'invention I: un procédé utilisant une traitment thermique à au moins 500°C pendant une durée inférieure ou égale à 5 minutes.
    L'invention II: un substrat revêtu d'une couche poreuse essentiellement minérale de type sol-gel présentant une série de pores fermés avec au moins la plus petite dimension caractéristique qui est supérieure ou égale à 20 nm.
    En comparant ces éléments techniques, il apparaît qu'il n'y a pas entre les groupes d'inventions d'effet technique correspondant qui lierait ces groupes de manière qu'ils ne forment qu'un seul concept inventif général.
    ---

2. revendications: 8-17

    Substrat revêtu d'une couche poreuse essentiellement minérale et de type sol-gel présentant une série de pores fermés avec au moins la plus petite dimension caractéristique qui est au moins 20 nm (revendication 8), l'utilisation du substrat revêtu selon la revendication 8 dans une module solaire (revendication 14), modules solaires comprenant le substrat revêtu selon la revendication 8 (les revendications 15 et 16) et un vitrage multiple (revendication 17) comportant un substrat revêtu selon la revendication 8.Les raisons pour lesquelles la présente demande porte sur 2 inventions non liées entre elles de telle sorte qu'elles ne formeraient qu'un seul concept inventif général, comme le requiert l'article 82, sont les suivantes:
    L'état de la technique cité dans la rapport de recherche décrit des substrats revêtus des couches poreuse (D1-D10) et des procédés pour fabriquer les mêmes utilisant l'agents porogène sous forme des particules polymériques (D1, D2,

EPO FORM P0402

Europäisches
Patentamt

European
Patent Office

Office européen
des brevets

**ABSENCE D'UNITÉ D'INVENTION
FEUILLE SUPPLÉMENTAIRE B**

Numéro de la demande

EP 11 18 7873

La division de la recherche estime que la présente demande de brevet européen ne satisfait pas à l'exigence relative à l'unité d'invention et concerne plusieurs inventions ou pluralités d'inventions, à savoir :

```
D5-D7) ou sous forme des nanogouttes (D10).
Les éléments suivants apparaissent donc comme les éléments
techniques particuliers au sens de l'article 82 CBE:
L'invention I: un procédé utilisant une traitment thermique
à au moins 500°C pendant une durée inférieure ou égale à 5
minutes.
L'invention II: un substrat revêtu d'une couche poreuse
essentiellement minérale de type sol-gel présentant une
série de pores fermés avec au moins la plus petite dimension
caractéristique qui est supérieure ou égale à 20 nm.
En comparant ces éléments techniques, il apparaît qu'il n'y
a pas entre les groupes d'inventions d'effet technique
correspondant qui lierait ces groupes de manière qu'ils ne
forment qu'un seul concept inventif général.
                          ---
```

EPO FORM P0402

**ANNEXE AU RAPPORT DE RECHERCHE EUROPEENNE**
**RELATIF A LA DEMANDE DE BREVET EUROPEEN NO.**

EP 11 18 7873

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-01-2012

| Document brevet cité au rapport de recherche | | | Date de publication | Membre(s) de la famille de brevet(s) | | | Date de publication |
|---|---|---|---|---|---|---|---|
| EP | 1659423 | A | 24-05-2006 | CN | 1776460 | A | 24-05-2006 |
| | | | | EP | 1659423 | A1 | 24-05-2006 |
| | | | | EP | 2259097 | A2 | 08-12-2010 |
| | | | | JP | 4792732 | B2 | 12-10-2011 |
| | | | | JP | 2006145709 | A | 08-06-2006 |
| US | 2006046045 | A1 | 02-03-2006 | JP | 2006070264 | A | 16-03-2006 |
| | | | | TW | I288827 | B | 21-10-2007 |
| | | | | US | 2006046045 | A1 | 02-03-2006 |
| FR | 2874007 | A | 10-02-2006 | | | | |
| EP | 1329433 | A | 23-07-2003 | EP | 1329433 | A1 | 23-07-2003 |
| | | | | ES | 2191542 | A1 | 01-09-2003 |
| US | 5871843 | A | 16-02-1999 | DE | 69730259 | D1 | 23-09-2004 |
| | | | | DE | 69730259 | T2 | 08-09-2005 |
| | | | | EP | 0798272 | A1 | 01-10-1997 |
| | | | | US | 5871843 | A | 16-02-1999 |
| JP | 7138046 | A | 30-05-1995 | JP | 3461016 | B2 | 27-10-2003 |
| | | | | JP | 7138046 | A | 30-05-1995 |
| WO | 2008059171 | A | 22-05-2008 | AT | 514109 | T | 15-07-2011 |
| | | | | EP | 2092379 | A2 | 26-08-2009 |
| | | | | FR | 2908523 | A1 | 16-05-2008 |
| | | | | WO | 2008059171 | A2 | 22-05-2008 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1329433 A
- WO 0205683 A
- US 5368892 A
- US 5389427 A
- EP 692463 A
- EP 0484746 A
- WO 2003046617 A

- US 6645645 B
- FR 2809496
- US 20040258929 A
- WO 2005049757 A
- EP 799873 A
- EP 0739042 A